# EUROPEAN PATENT SPECIFICATION

(11) **EP 2 699 071 B1**
(45) Date of publication and mention of the grant of the patent: **09.11.2016**
(21) Application number: 13180071.6
(22) Date of filing: 12.08.2013
(51) Int. Cl.: H05K 13/04

(54) **Head module for pick and place dedicated components in SMT technology**
Kopfmodul zur Aufnahme und Platzierung von dedizierten Komponenten in SMT-Technologie
Module de tête de préhension et de mise en place de composants spécialisés dans la technologie de SMT

(30) Priority: 14.08.2012 PL 40038412
(43) Date of publication of application: 19.02.2014
(73) Proprietor: Wladyslaw Wlodarczyk IGLOO, 32-720 Nowy Wisnicz (PL)
(72) Inventor: Wlodarczyk, Milosz, 32-700 Bochnia (PL)
(74) Representative: Hudy, Ludwik

(56) References cited:
- DE-A1- 10 304 970
- JP-A- 2003 163 493
- US-A1- 2004 231 148

## Description

This invention relates to the head module for positioning SMD (Surface Mount Device) electronic components or elements on PCBs (Printed Circuit Boards) using SMT technology (Surface Mount Technology) in assembly semi-automatons and automatons, particularly for pick and place dedicated components in SMT technology, according to the preamble of claim 1. A head module can comprise a body of the head module, a suction nozzle assembly with a gripping component comprising a negative pressure duct inside the gripping component, which at one end is equipped with a suction nozzle gripping the dedicated components, to which a pressure connector is connected supplying negative pressure to the negative pressure duct, which connects with a centre through hole of the suction nozzle gripping, and the linear displacement drive of the gripping component in relation to the body of the head module mounted to the body of the head module.

Positioning electronic components is based on picking them up from feeders or containers, where SMD components are collected, and placing them in a given location on the PCB surface. In known solutions, positioning the SMD components is executed by heads.

Application US 200810315603 A1 titled "Pick and place system" discloses a system for picking up and placing electronic components, that comprises a sampler with a negative pressure duct, a sampler linear displacement system with a linear driving system, a sampler rotary displacement system with a rotary driving system as well as a negative pressure supply system to the sampler, in order to pick up and displace a micro-component. Said displacement of the micro-component is performed away from main assembly lines. Whereas various supply machines and automatic displacement systems equip printed circuit boards with the micro-components, operations related to processing, treatment of integrated circuits, such as programming, testing, calibrating and measuring, are substantially performed rather in separate divisions, on separate devices, not on main production assembly lines.

Application US2007059149 A1 titled "Multi-axis pick and place assembly" discloses a picking up and placing system for picking up and positioning different components. The system comprises a spindle with a chamber equipped with a head for picking up the components, to which negative pressure is supplied via a housing and a sealing set located between the housing and the spindle displaced using a driving system.

Application US2004042890 A1 titled "Component-placing apparatus" discloses a device with a negative pressure nozzle for placing components and with a rotary actuator and a linear actuator, which are fixed in relation to each other. The negative pressure nozzle is equipped with a suction nozzle at the bottom, which can move using rotary motion and translational motion.

Application US2009056114 A1 titled "Nozzle mechanism, mounting head and electronic component mounting apparatus" discloses a nozzle mechanism, a mounting head and a device for mounting electronic components. The nozzle mechanism has a rotating mechanism that transfers power from an engine to a nozzle catching the electronic components by a bar, which is mounted directly on an engine wheel and a nozzle wheel.

Application JP 2003163493 titled "Installing head of electronic part mounting device" teaches an installing head of an electronic part mounting device that comprises an absorption nozzle to pick and place an electronic part using negative pressure air to install it at a specified position on a circuit board, a turning means that turns the absorption nozzle around its own axis, and a vertical movement means that vertically moves the absorption nozzle. A turning motor provided to the turning means is placed together with a vertical movement motor provided to the vertical movement means placed on a slide unit.

Furthermore, Application US 2004/0231148 titled "Head for implanting electrical components on substrates" teaches an insertion head with a drive shaft bearing a mechanism for gripping a component, whereby said shaft is capable of being driven by a drive motor. The drive shaft is directly formed by the hollow output shaft of the drive motor. The insertion head essentially includes a slide device, which has two slide components that can be moved toward each other in a Z direction, whereby the drive motor is attached to one slide component.

In addition, Application DE 103 04 970 titled "Positioniereinheit mit einem Kraftsensor" teaches a positioning unit for attachment electronic elements to a printed board. The positioning unit comprises a housing, a shaft, a rotating drive, a linear drive and a mounting element that is attached to the shaft where it extends from the housing. A force sensor is coupled to the shaft and measures counter forces acting along the shaft axis that are applied against the mounting element. The force sensor output is delivered to the linear drive so that its speed, acceleration and/or drive force can be adjusted accordingly. The linear drive is moved together with the whole holding element.

The drawback of the known solutions is the necessity to employ complicated heads, comprising many components thus their production and operation are expensive and problematic.

A purpose of this invention is to create a head module to pick up and place SMD components, deprived of the aforementioned drawbacks and inconveniences, known from the known solutions.

This object of invention is achieved by the head module with the features of claim 1. Advantageous embodiments are given in the dependent claims. In a case of a head module to pick up and place dedicated components in the SMT technology, according to the invention it is provided a head module comprising a body of the head module, a suction nozzle assembly with a gripping component comprising a vacuum duct inside the gripping component, which at one end is equipped with a suction nozzle gripping the dedicated components, to which a vacuum connector is connected supplying vacuum or negative pressure to the vacuum duct by using which the dedicated components are sucked to the suction nozzle. The vacuum or negative pressure is so great that after capture the dedicated component by the nozzle, the dedicated component does not move relative to the suction nozzle.

Indeed the dedicated component does not move relative to the suction nozzle but due to the fact that the nozzle is attached to the gripping element, which can perform rotary motion around its own axis and move vertically, the dedicated component can move in rotation and movement in the vertical direction relative to the PCB on which the dedicated component is to be placed. The described movements are realized by means of a drive generating rotary motion of the gripping component and a drive for linear movement of the gripping component in relation to the body of the head module, from which only the drive for linear movement is installed on the body of the head module. Because the body of the head module together with the head module is seated on a carriage displacing, the head module can displace in a plane perpendicular to the axis of rotation of the gripping component, that is, in a plane parallel to a plane of the PCB, and stopped over the place where the dedicated component is to be placed. Thanks to the compact head module, on the trolley moving the head module can be placed more than one body of the head module with the module head.

The first basic idea of the invention consists in using, as the drive of the gripping component, generating rotary motion of the gripping component, a stepping or stepper motor installed by its housing to the body of the head module. However, a stepper motor shaft is a hollow shaft, inside which the gripping component is seated and coupled displaceably along the hollow shaft axis, using a clearance-free guide coupling the sleeve with the hollow shaft. The gripping component has vacuum duct hollowed inside, which connects with a centre through hole of the suction nozzle gripping the dedicated components using the suction end.

A large simplification of the head module construction is apply as the linear displacement drive of the gripping component in relation to the body of the head module the belt transmission with the tensioning pulley and drive pulley seated on the motor shaft generating motion of the belt of the belt transmission, on which a holder with a rotary seated gripping component is fixed.

The axis of rotation of the gripping component may be disposed coaxially with the axis of rotation of the hollow shaft of the stepper motor, which also simplifies the design of the head module. Preferably, the clearance-free guide coupling sleeve is seated on the hollow shaft of the stepper motor and is coupled with the hollow shaft of the stepper motor using a screw screwed into the coupling sleeve fixing the hollow shaft with the coupling sleeve, which is coupled by a spline with the gripping component linearly displaced along the symmetry axis of the hollow shaft in relation to the body.

The accuracy of the vertical movement of a dedicated component, thus preventing damage of the PCB is provided by using a belt transmission with toothed belt, and a tensioning pulley and a driving pulley that are toothed pulleys.

To ensure fast picking up of the dedicated components at the second end of the gripping component, there is a pressure connector installed that supplies vacuum or negative pressure to the vacuum duct of the gripping component, which is on the opposite side of the gripping element where the suction nozzle is fixed.

A subject of the invention is presented in the embodiments in the drawings, in which Fig. 1 presents an axonometric view of a head module, Fig. 2 presents an axonometric view of the head module with details of connector of a stepping motor axis with a clearance-free guide and fixing of a belt with a suction nozzle assembly, Fig. 3 presents longitudinal cross-section of a gripping component, Fig. 4 presents head modules located on a carriage and used to position SMD electronic components, Fig. 5 presents a pneumatic system generating vacuum or negative pressure in a flexible hose supplying vacuum or negative pressure and a vacuum duct located inside the gripping component with a suction nozzle, and Fig. 6 presents a diagram of an electrical system.

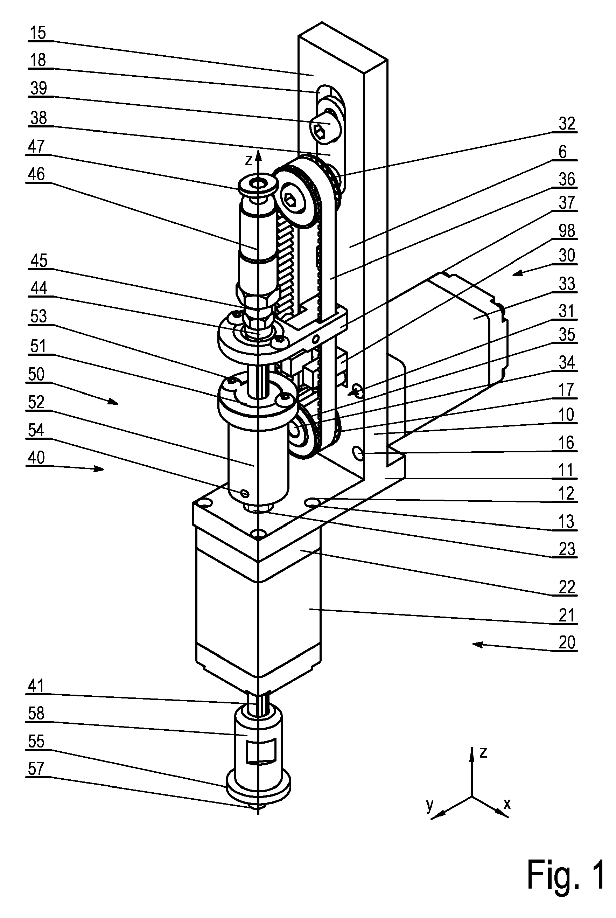

A head module 5, presented in Fig. 1, 2, 3 and 4 is used to pick up and place dedicated components in SMT technology, which for example, are electronic components mountable on the flat surface. These components are picked up from a feeder (not shown in the drawing) and then transported to the place of their assembly on PCB. The mentioned head module 5 comprises a body 10 of the head module 5, a suction nozzle assembly 40 with a gripping component 41, a drive 20 of the gripping component 41 generating rotary motion of the gripping component and a drive 30 for linear displacement of the gripping component 41 in relation to the body 10 of the head module 5 fixed to the body 10 of the head module 5.

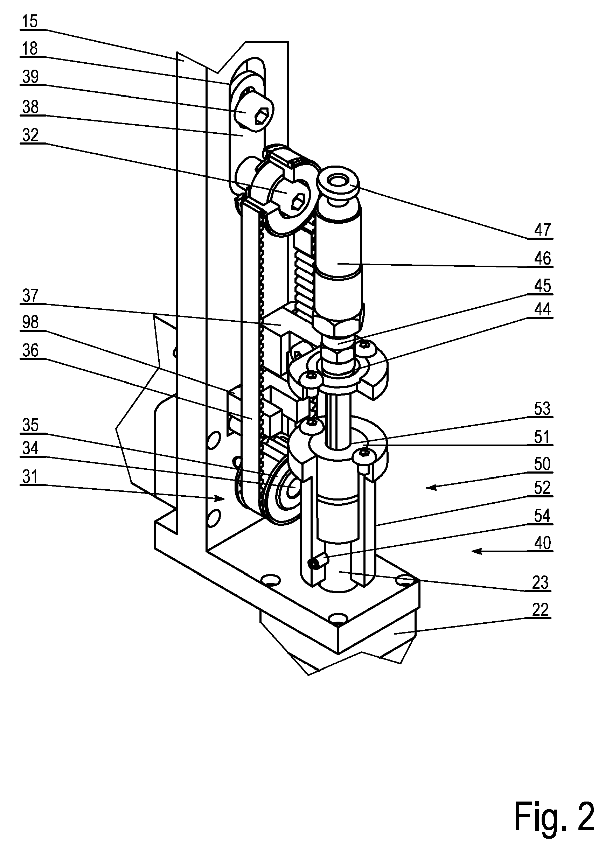

The body 10 of the head module 5 has its base 11 in a shape of a flat bar with stepped through holes 12 in which screws 13 are located, by which a housing 22 of a stepper motor 21 is fixed to the base 11 of the body 10 from the bottom of the base 11, adopting the positioning of the body 10 presented in the Figs. 1 and 2 as the reference positioning, in case of which the stepper motor 21 is located at the bottom of the figure.

Additionally, the body 10 has an arm 15 which stands out from the base 11 at an angle, for example 90°. The arm 15 has the shape of a flat bar and as the base 11, has stepped through holes 16 for fixing a motor 33 for linear displacement of the gripping component 41 in relation to the body 10 of the head module 5. The base 11 and the arm 15 of the body 10 form a partial shield of the assembly 40 of the suction nozzle with the gripping component 41 and limit a space 6 from the bottom and rear, in which the assembly 40 of the suction nozzle with the gripping component 41 is located. A shaft 34 of the motor 33 passes through the hole 17 made in the bottom part of the arm 15 located adjacent to the base 11 of the body 10. On the shaft 34, which protrudes from the hole 17, a driving pulley 35 is seated, which is wound by a belt 36 of a belt transmission 31, of which a belt tensioning pulley 32 is fixed to an assembly 38 that tensions or tightens the belt 36 of the belt transmission 31. Location of the assembly 38 tensioning the belt 36 of the belt transmission 31 is set using a set screw 39, which locks the position of the assembly 38 located in a longitudinal hole 18 located in the upper part of the arm 15 of the body 10. On the belt 36 of the belt transmission 31, a holder 37 is mounted non-displaceably in relation to the belt and provided with an optical diaphragm, in which a gripping component 41 is seated. Displacement of the belt 36 of the belt transmission 31 in relation to the body 10 generates linear displacement of the gripping component 41 in respect to the body 10, which is controlled by means of an optical switch 98 of end position of gripping element 41 of the suction nozzle 55.

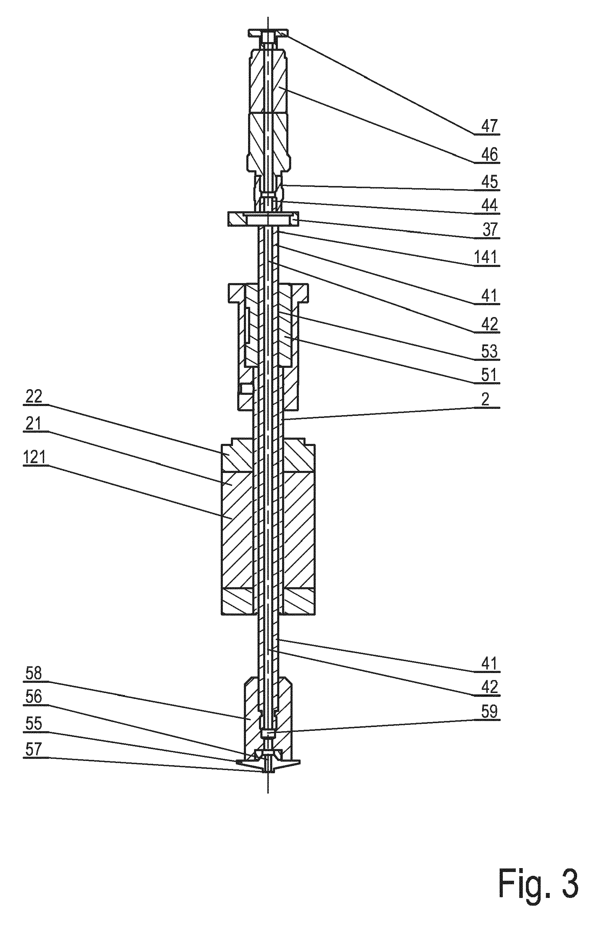

The stepper motor 21, fixed by its housing 22 to the body 10 of the head module 5, has a hollow shaft 23 in which the gripping component 41 is centrally fixed, which can move inside the hollow shaft 23 along its axis, and which is coupled using a coupling sleeve 52 of a clearance-free guide or backlash-free guide 50 with the hollow shaft 23. The coupling sleeve 52, presented in Fig. 2, of the clearance-free guide 50 is seated on the hollow shaft 23 of the stepper motor 21 and is coupled with the hollow shaft 23 of the stepper motor 21 using the screw 54 screwed into the coupling sleeve 52 and fixing the hollow shaft 23 in relation to the coupling sleeve 52, inside which there is an internal coupler 51, and which, using the spline 53, is coupled with the gripping component 41 which moves linearly along the symmetry axis of the hollow shaft 23 in relation to the body 10 and rotatable around its own symmetry axis overlapping with the axis shown in the Fig. 1. In Fig. 3 presenting the longitudinal cross section of the gripping component 41, the internal connector 51 of the clearance-free guide 50 has a spline inside its through hole, however the gripping component 41 has splines shaped on its side surface, which dimensions and shape allows sliding displacement of the gripping component 41 in relation to the internal connector 51 of the clearance-free guide 50. The gripping component 41 has a threaded end 44 on the top, which is connected with a muff 45 using threaded connection. The muff 45 is equipped with a rotational pressure connector 46 with a stub pipe 47, which allows connecting the pneumatic hose supplying vacuum or negative pressure to a vacuum duct 42 located inside the gripping component 41. At the bottom of the gripping component 41, there is a suction nozzle 55 replaceably connected using a magnet to a conical seat 58, to which a suction nozzle 57 is connected, of which a centric hole 59 is connected with the centric through hole 56 of the suction nozzle 55 and the duct 42 of the gripping component 41. The axis of rotation 141 of the gripping component 41 is positioned coaxially with the axis of rotation 121 of the hollow shaft 23 of the stepper motor 21. The suction nozzle 55 is designed to firmly grip the SMD dedicated component, take it out from the feeder, for example a cassette tape feeder for positioning SMD electronic components used to supply SMD components from belts in assembly automatons or semi-automatons, using the SMT technology and transport the SMD dedicated component, generally called an electronic component, to the specified location and place it in the predetermined location on the board.

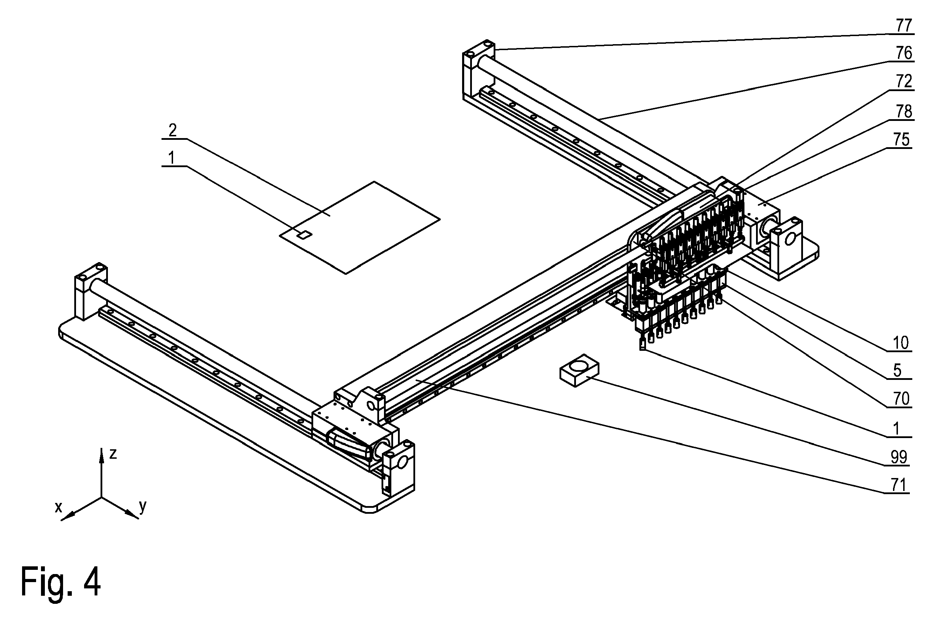

Fig. 4 presents ten bodies 10 of the head modules 5, used to position the SMD electronic components placed one by another on a carriage 70, which can move horizontally. The carriage 70 is located on a transversal guide 71 and is equipped with one drive 72, which forces displacement of the carriage 70 along the transversal guide 71, which is seated on movable supports 75 fixed to the transversal guide 71 and movable slidingly along horizontal guides 76. Each of the horizontal guides 76 is supported at its ends on vertical supports 77, and the movable supports 75 have their own drive systems 78, which are synchronized with each other so that the transversal beam 71 moves at right angle in relation to the horizontal guides 76. With an arrangement of the transversal guide 71 and the horizontal guides 76 and corresponding drives, each of the head modules 5 can be displaced above any pre-determined location, located in the xy plane.

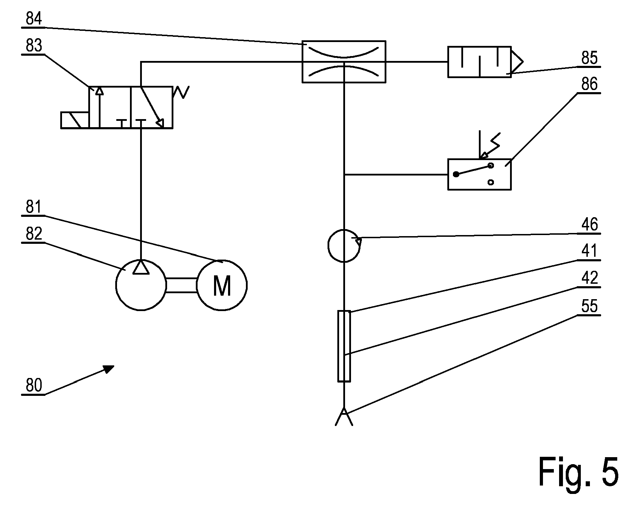

A pneumatic system 80 generating vacuum or negative pressure in the flexible hose supplying vacuum or negative pressure and the vacuum duct 42 located inside the gripping component 41 with the suction nozzle 55 is presented in Fig. 5. The pneumatic system 80 comprises a pump 82, which is driven by a motor 81, a switching solenoid valve 83, an ejector 84, generating vacuum in the vacuum duct 42 of the gripping component 41 and a discharge valve 85. Vacuum or negative pressure supplied to the suction nozzle 55 is changed using the stepwise method by application of a cut-off valve 86, thus the suction nozzle 55 sucks and holds the electronic component only when vacuum or negative pressure is supplied to it, and after cutting off the vacuum or the negative pressure, the suction nozzle 55 releases and leaves the electronic components in the pre-determined place.

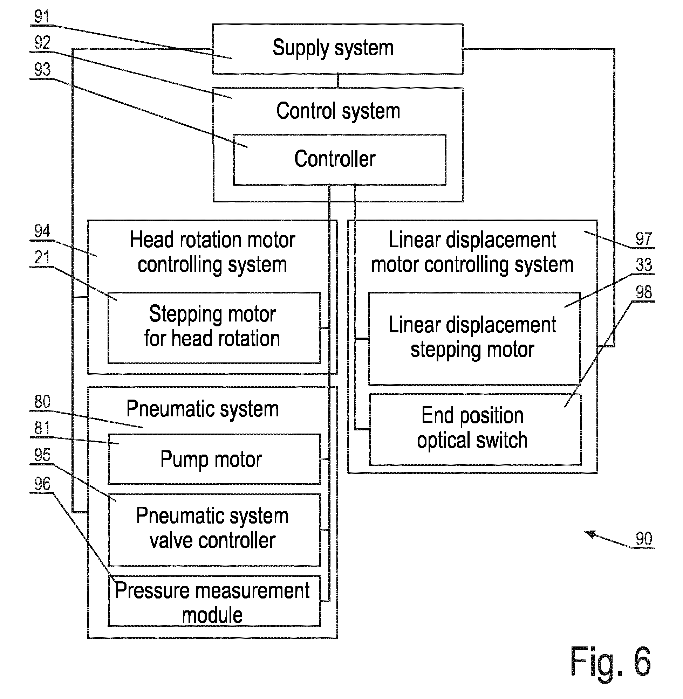

Fig. 6 schematically presents an electric system 90, which comprises main systems such as a supply system 91 and a control system 92 with a controller 93. To the supply system 91 and the control system 92, the following systems are connected: a system 94 controlling the stepper motor 21 of the gripping component rotation with the suction nozzle, a pneumatic system 80 with a pump motor 82, controllers 95 of the pneumatic system 80 valves and a vacuum measurement module 96 as well as a system 97 controlling the stepper motor 33 for linear movement of the gripping component with the suction nozzle, with optical switch 98 of end position of the gripping component with the suction nozzle.

While collecting the dedicated components, the assembly 40 of the suction nozzle with the gripping component 41 is displaced over the feeder container with specified electronic components. In the duct 42 of the gripping component 41, vacuum or negative pressure is generated which causes that a specified electronic component 1, shown in Fig. 4, is being sucked to the replaceable suction nozzle 55 located at the bottom of the gripping component 41, after displacing the suction nozzle together with the gripping component to the electronic component 1 using the drive 30 for linear movement of the gripping component 41 in relation of the body 10 of the head module 5, namely, using the belt transmission 31 generating motion of the belt 36, on which a holder 37 is mounted non-displaceably in respect to the belt with the gripping component 41 rotationally assembled inside it. After gripping the electronic component 1, the gripping component 41 together with the electronic component 1 is displaced over a device 99, shown in Fig. 4, for example a camera, controlling the location of the electronic component 1 in relation to the longitudinal symmetry axis of the gripping component 41 or other reference point located on the gripping component 41 or the head module 5. If it is found that the location of the electronic component have to be corrected, the electronic component 1 is rotated using the drive 20 of the gripping component 41 generating the rotary motion of the gripping component 41, namely using the stepper motor 21 installed by its housing 22 to the body 10 of the head module 5. If the electronic component 1 is correctly located in relation to the head, the gripping component 41 is displaced together with the carriage over the pre-determined position over the board 2, then the electronic component is moved downwards, until it contacts with the printed circuit board 2, which is controlled by the control system with the set end bottom position of the suction nozzle. An additional protection against displacement of the suction nozzle too far towards the bottom is the optical switch of end position, operating together with the optical diaphragm, which cuts a light beam between the optical transmitter and the receiver in the optical switch of end position. After placing the electronic component 1 on the printed circuit board 2, the electronic component 1 is released by the gripping component 41, after equalizing the pressured in the vacuum duct in relation to ambient pressure. The controlled solenoid valve 83 activating vacuum or negative pressure is activated by the controller 95 of the pneumatic system valves during picking up the components. Information that the head has picked up the electronic component is obtained from the pressure sensor, which sends proper information when the preset value of vacuum or negative pressure is achieved. The preset value of negative pressure is established when the suction nozzle touches the flat surface of the component, because negative pressure rise occurs, or the PCB surface. Vacuum or negative pressure rise caused by contact with the printed board is also used to specify the reference height, i.e. so called zero height, which is to be used to determine the height of lowering the electronic components during their placement on the printed board.

The feature distinguishing the operation of the head module for picking up and placing the dedicated components in the SMT technology from the other heads is simplification of the mechanism by application of the hollow shaft of the stepping motor setting in rotary motion the gripping component, which is located inside the hollow shaft of the stepper motor. Positioning of the gripping component inside the hollow shaft of the stepper motor, protruding from the both sides of the stepper motor shaft allows to reduce the number of components of the head module, especially when comparing the head presented in this application with the mechanism from other solutions, where rotation around the vertical axis is executed using the motor and belt transmission.

The solution according to the invention is presented in relation to selected embodiments. These embodiments do not limit the invention. It is obvious that modifications can be introduced without deviating from the nature of the solution. The presented embodiments do not exhaust all applications of the solution according to the invention.

## Claims

1. A head module (5) for pick and place dedicated components in SMT technology, comprising a body (10) of a head module (5), a suction nozzle assembly (40) with a gripping element (41) comprising a vacuum duct (42) inside the gripping element (41), which at one end is equipped with a suction nozzle for gripping dedicated components, to which at the opposite end of the suction nozzle a pressure connector is connected supplying vacuum or negative pressure to the vacuum duct which is connected with a through hole of the suction nozzle, a drive (20) of the gripping element being a stepper motor (21) with a hollow shaft (23) and generating a rotary motion of the gripping component (41) and a drive (30) for linear movement of the gripping component in relation to the body of the head module mounted on the body of the head module, wherein the stepper motor (21) is mounted by its housing (22) to the body (10) of the head module (5) and inside the hollow shaft (23) of the stepper motor (21) the gripping component (41) is seated and coupled displaceably along a hollow shaft (23) axis, using a coupling sleeve (52) of a clearance-free guide (50) with the hollow shaft (23), while the gripping component (41) has the vacuum duct (42) hollow inside, which is connected with a centre through hole (56) of the suction nozzle (55) gripping the dedicated components using the suction end (57), and the drive (30) of linear displacement of the gripping component (41) in relation to the body (10) of the head module (5) is a belt transmission (31) with a belt tensioning pulley (32) mounted to an arm (15) of the base of the body (10) of the head module to which arm (15) a motor (33) is fixed having a shaft (34) on which a drive pulley (35) is seated generating motion of a belt (36) of the belt transmission (31) and displacement of the belt (36) in relation to the body (10) generates linear displacement of the gripping component (41) in respect to the body (10) , and wherein a holder (37)) is non-displaceably mounted in relation to the belt (36) and in which the gripping component (41) is seated, whereas the holder (37) allows movement of the rotary seated gripping component (41) rotationally in relation to the holder (37).

2. The head module according to claim 1, **characterized in that** the coupling sleeve (52) of the clearance-free guide (50) is seated on the hollow shaft (23) of the stepper motor (21) and is coupled with the hollow shaft (23) of the stepper motor (21) using a screw (54) screwed into the coupling sleeve (52) fixing the hollow shaft (23) to the coupling sleeve (52), which is coupled by a spline (53) with the gripping component (41) linearly displaceable along the symmetry axis of the hollow shaft (23) in relation to the body (10).

3. The head module according to claim 1 or 2 **characterized in that** an axis (141) of rotation of the gripping component (41) is disposed coaxially with an axis (121) of rotation of the hollow shaft (23) of the stepping motor (21).

4. The head module according to claim 1 or 2 or 3 **characterized in that** the belt transmission (31) is the belt transmission (31) with a toothed belt (36), and the belt tensioning pulley (32) and the drive pulley (35) are toothed pulleys.

5. The head module according to claim 1 or 2 or 3 or 4 **characterized in that** the belt tensioning pulley (32) is seated on bearings in tensioning arrangement (38) of the toothed belt (36) displaceable in relation to the drive pulley (35).

6. The head module according to claim 1 or 2 or 3 or 4 or 5 **characterized in that** at the other end of the gripping component (41) opposite the side where the suction nozzle is fixed a pressure connector (46) is installed, which supplies vacuum or negative pressure to the vacuum duct (42) of the gripping component (41).

7. The head module according to claim 1 or 2 or 3 or 4 or 5 or 6 **characterized in that** the body (10) of the head module (5) together with the head module (5) is seated on a carriage (70) moving the head module (5) in a plane perpendicular to the axis of rotation of the gripping component (41).

8. The head module according to claim 7 **characterized in that** on the carriage (70) moving the head module (5) more than one head module (5) are placed one by another, the bodies of the head modules being seated on the carriage (70) together with the respective head modules.

## Patentansprüche

1. Ein Kopfmodul (5) zur Aufnahme und Platzierung von dedizierten Komponenten in SMT-Technologie, beinhaltend einen Körper (10) des Kopfmoduls (5), einen Saugdüsensatz (40) mit einem Greifelement (41), wobei innerhalb des Greifelements sich ein Unterdruckkanal (42) befindet, wobei das Greifelement an einem Ende mit einer Saugdüse zum Erfassen von dedizierten Komponenten ausgestattet ist, wobei an das Greifelement ein Druckanschluss angeschlossen ist, über welchen dem mit einer durchgehenden Öffnung der Saugdüse verbundenen Unterdruckkanal Unterdruck zugeführt wird, einen Antrieb (20) des Greifelements in der Form eines Schrittmotors (21) mit einer Hohlwelle (23), der eine Drehbewegung des Greifelements (41) hervorruft, sowie einen an dem Körper des Kopfmoduls befestigten Antrieb (30) für die lineare Verschiebung des Greifelements in Bezug auf den Körper des Kopfmoduls, wobei der Schrittmotor (21) über sein Gehäuse (22) an dem Körper (10) des Kopfmoduls (5) befestigt ist, wobei innerhalb der Hohlwelle (23) des Schrittmotors (21) das Greifelement (41) gelagert ist, das mittels einer Kupplungsmuffe (52) einer spielfreien Führung (50) entlang einer Achse der Hohlwelle (23) verschiebbar mit der Hohlwelle (23) gekoppelt ist, wobei das Greifelement (41) einen innen hohlen Unterdruckkanal (42) aufweist, der mit einer zentrischen Durchgangsöffnung (56) der Saugdüse (55) verbunden ist, welche die dedizierten Komponenten mittels eines Saugendstücks (57) erfasst, wobei der Antrieb (30) für die lineare Verschiebung des Greifelements (41) in Bezug auf den Körper (10) des Kopfmoduls (5) ein Riemengetriebe (31) mit einer Spannscheibe (32) ist, die an einem Arm (15) der Basis des Körpers (10) des Kopfmoduls (5) montiert ist, wobei an dem Arm (15) ein Motor (33) befestigt ist, der eine Welle (34) aufweist, auf welcher eine Antriebsscheibe (35) aufgesetzt ist, die eine Bewegung des Riemens (36) des Riemengetriebes (31) verursacht, wobei eine Verschiebung des Riemens (36) in Bezug auf den Körper (10) eine lineare Verschiebung des Greifelements (41) in Bezug auf den Körper (10) verursacht, wobei ein Griff (37) in Bezug auf den Riemen (36) unverschiebbar befestigt ist, wobei das Greifelement (41) in dem Griff (37) drehbar gelagert ist, und wobei der Griff (37) eine Bewegung des drehbar gelagerten Greifelements (41) im Verhältnis zum Griff (37) ermöglicht.

2. Das Kopfmodul nach Anspruch 1, **dadurch gekennzeichnet, dass** eine Kupplungsmuffe (52) der spielfreien Führung (50) auf die Hohlwelle (23) des Schrittmotors (21) aufgesetzt und mit der Hohlwelle (23) des Schrittmotors (21) mittels einer in die Kupplungsmuffe (52) eingedrehten Schraube (54) gekoppelt ist, welche die Hohlwelle (23) an der Kupplungsmuffe (52) fixiert, die über eine Vielkeilverbindung (53) mit dem Greifelement (41) gekoppelt ist, wobei das Greifelement (41) entlang der Symmetrieachse der Hohlwelle (23) in Bezug auf den Körper (10) linear verschiebbar ist.

3. Das Kopfmodul nach Anspruch 1 oder 2, **dadurch gekennzeichnet, dass** eine Drehachse (141) des Greifelements (41) koaxial mit einer Drehachse (121) der Hohlwelle (23) des Schrittmotors (21) angeordnet ist.

4. Das Kopfmodul nach Anspruch 1 oder 2 oder 3, **dadurch gekennzeichnet, dass** das Riemengetriebe (31) einen Zahnriemen (36) aufweist und dass die Spannscheibe (32) und die Antriebsscheibe (35) Zahnscheiben sind.

5. Das Kopfmodul nach Anspruch 1 oder 2 oder 3 oder 4, **dadurch gekennzeichnet, dass** die Spannscheibe (32) in einem Spannsystem (38) des Zahnriemens (36) in Bezug auf die Antriebsscheibe (35) verschiebbar gelagert ist.

6. Das Kopfmodul nach Anspruch 1 oder 2 oder 3 oder 4 oder 5, **dadurch gekennzeichnet, dass** am anderen Ende des Greifelements (41) ein Druckanschluss (46) montiert ist, über welchen dem Unterdruckkanal (42) des Greifelements (41) Unterdruck zugeführt wird.

7. Das Kopfmodul nach Anspruch 1 oder 2 oder 3 oder 4 oder 5 oder 6, **dadurch gekennzeichnet, dass** der Körper (10) des Kopfmoduls (5) zusammen mit dem Kopfmodul (5) auf einem Wagen (70) aufsitzt, welcher das Kopfmodul (5) in einer zur Drehachse des Greifelements (41) senkrechten Ebene bewegt.

8. Das Kopfmodul nach Anspruch 7, **dadurch gekennzeichnet, dass** an dem den Kopfmodul (5) verlagernden Wagen (70) mehr als ein Körper (10) des Kopfmoduls (5) zusammen mit dem Kopfmodul (5) angeordnet ist.

## Revendications

1. Un module de tête (5) de préhension et de mise en place de composants spécialisés dans la technologie de SMT comprenant un corps (10) du module de tête (5), un ensemble (40) de buse d'aspiration avec un élément de préhension (41) comprenant un conduit (42) d'aspiration à l'intérieur de l'élément de préhension (41), dont une extrémité est équipée d'une buse d'aspiration pour saisir les composants destinés, et à laquelle à l'extrémité opposée de la buse d'aspiration un raccord de pression d'alimentation est relié à vide ou sous pression négative à la conduite d'aspiration qui est reliée à un trou traversant la buse d'aspiration, un entraînement (20) de l'élément de préhension étant un moteur pas à pas (21) avec un arbre creux (23) et générant un mouvement de rotation de l'élément de préhension (41) et un entraînement (30) pour un mouvement linéaire de l'organe de préhension par rapport au corps du module de tête monté sur le corps du module de tête, dans lequel le moteur pas à pas (21) est monté par son boîtier (22) au corps (10) du module de tête (5) et à l'intérieur de l'arbre creux (23) du moteur pas à pas (23) l'élément de préhension (41) est placé et couplé mobile le long de l'axe de l'arbre creux (23), au moyen d'un manchon d'accouplement (52) d'un guidage sans jeu (50) avec l'arbre creux (23), tandis que l'élément de préhension (41) comporte un conduit d'aspiration (42) creux à l'intérieur, qui est relié à un trou traversai central (56) de la buse d'aspiration (55) saisissant les composants destinés en utilisant l'extrémité d'aspiration (57), et l'entraînement (30) de déplacement linéaire de l'élément de préhension (41) par rapport au corps (10) du module de tête (5) est une transmission à courroie (31) avec une poulie de tension (32) montée sur un bras (15) de la base du corps (10) du module de tête à laquelle le bras (15), est fixé un moteur (33) avec un arbre (34) sur lequel est placée une poulie d'entraînement (35) générant de mouvement d'une courroie (36) de la transmission à courroie (31) et le déplacement de la courroie (36) par rapport au corps (10) engendre un déplacement linéaire de l'élément de préhension (41) relativement au corps (10), et dans lequel un support (37) est monté non mobile par rapport à la courroie (36) et dans lequel l'élément de préhension (41) est placé, tandis que le support (37) permet un mouvement de l'élément de préhension (41) placé rotatif en rotation par rapport au support (37).

2. Le module de tête selon la revendication 1, **caractérisé en ce que** le manchon d'accouplement (52) du guidage sans jeu (50) est placé sur l'arbre creux (23) du moteur pas à pas (21) et est couplé à l'arbre creux (23) du moteur pas à pas (21) à l'aide d'une vis (54) vissée dans le manchon d'accouplement (52), fixant l'arbre creux (23) au manchon d'accouplement (52), qui est couplé par une cannelure (53) avec l'élément de préhension (41) pouvant être déplacé linéairement le long de l'axe de symétrie de l'arbre creux (23) par rapport au corps (10).

3. Le module de tête selon la revendication 1 ou 2, **caractérisé en ce qu'**un axe (141) de rotation de l'élément de préhension (41) est disposé de manière coaxiale avec un axe (121) de rotation de l'arbre creux (23) du moteur pas à pas (21).

4. Le module de tête selon la revendication 1 ou 2 ou 3, **caractérisé en ce que** la transmission à courroie (31) est une transmission à courroie (31) avec une courroie dentée (36) et la poulie de tension (32) et la poulie d'entraînement (35) sont des poulies dentées.

5. Le module de tête selon la revendication 1 ou 2 ou 3 ou 4, **caractérisé en ce que** la poulie de tension (32) repose l'enroulement (38) de la courroie dentée (36) pouvant être déplacé par rapport à la poulie d'entraînement (35).

6. Le module de tête selon la revendication 1 ou 2 ou 3 ou 4 ou 5, **caractérisé en ce qu'**à l'autre extrémité de l'élément de préhension (41) à l'opposé du côté où la buse d'aspiration est fixé un raccord de pression (46) est installée, qui fournit vide ou une pression négative à la conduite sous vide (42) de l'élément de préhension (41).

7. Le module de tête selon la revendication 1 ou 2 ou 3 ou 4 ou 5 ou 6, **caractérisé en ce que** le corps (10) du module de tête (5) conjointement avec le module de tête (5) est placé sur un chariot (70) déplaçant le module de tête (5) dans un plan perpendiculaire à l'axe de rotation de l'élément de préhension (41).

8. Le module de tête selon la revendication 7, **caractérisé en ce que** sur le chariot (70) déplaçant le module de tête (5) plus d'un module de tête (5) sont placés l'un par l'autre, les corps des modules de tête étant logée sur le chariot (70) conjointement avec les modules de tête respectifs.
